# EUROPÄISCHE PATENTSCHRIFT

(11) **EP 3 137 913 B1**
(45) Veröffentlichungstag und Bekanntmachung des Hinweises auf die Patenterteilung: **01.05.2019**
(21) Anmeldenummer: 15713669.8
(22) Anmeldetag: 23.03.2015
(51) Int. Cl.: G01R 31/02

(54) **KURZSCHLUSSSENSOR**
SHORT-CIRCUIT SENSOR
DÉTECTEUR DE COURT-CIRCUIT

(30) Priorität: 30.04.2014 DE 102014106130
(43) Veröffentlichungstag der Anmeldung: 08.03.2017
(73) Patentinhaber: Phoenix Contact GmbH & Co. KG, 32825 Blomberg (DE)
(72) Erfinder: SCHAPER, Elmar, 32676 Lügde (DE); SCHOLZ, Peter, 33034 Brakel (DE)
(74) Vertreter: Patentship Patentanwaltsgesellschaft mbH
(86) Internationale Anmeldenummer: PCT/EP2015/056081
(87) Internationale Veröffentlichungsnummer: WO 2015/165646

(56) Entgegenhaltungen:
- US-A1- 2008 043 383
- US-A1- 2012 239 319
- GERBER DOMINIC ET AL: "Gate Unit With Improved Short-Circuit Detection and Turn-Off Capability for 4.5-kV Press-Pack IGBTs Operated at 4-kA Pulse Current", IEEE TRANSACTIONS ON PLASMA SCIENCE, IEEE SERVICE CENTER, PISCATAWAY, NJ, US, Bd. 41, Nr. 10, 1. Oktober 2013 (2013-10-01), Seiten 2641-2648, XP011529105, ISSN: 0093-3813, DOI: 10.1109/TPS.2013.2280379 [gefunden am 2013-10-07]
- GUILLOD T ET AL: "Design of a PCB Rogowski Coil based on the PEEC Method", INTEGRATED POWER ELECTRONICS SYSTEMS (CIPS), 2012 7TH INTERNATIONAL CONFERENCE ON, VDE VERLAG GMBH, 6. März 2012 (2012-03-06), Seiten 1-6, XP032181456, ISBN: 978-3-8007-3414-6

## Beschreibung

Die vorliegende Erfindung betrifft einen Kurzschlusssensor zum Erfassen eines Kurzschlussstromes in einer Stromleitung, beispielsweise einer Netzstromleitung mit 50/60Hz.

In Kurzschlusssensoren wird ein möglicher Kurzschlussstrom von einem normalen Überstrom unterschieden. Ein Kurzschlussstrom hat typischerweise einen sehr viel schnelleren Anstieg als ein normaler Einschaltstrom eines Verbrauchers oder Elektromotors.

Der Artikel von Gerber et al: "Gate Unit With Improved Short-Circuit Detection and Turn-Off Capability for 4.5-kV Press-Pack IGBTs Operated at 4-kA Pulse Current", IEEE Transactions on Plasma Science, Vol. 41, No. 10, vom Oktober 2013 (D1) offenbart einen Kurzschlussschutz für ein Insulated-Gate Bipolar Transistor (IGBT) Pack (D1).

Der Artikel von Guillod et al: "Design of a PCB Rogowski Coil based on the PEEC Method", 7th International Conference on Integrated Power Electronics Systems (CIPS), Proceedings, vom März 2012 (D2) offenbart ein Design einer PCB Rogowski Spule auf Basis der PEEC-Methode (D2).

Die Druckschrift US 2012/0239319 A1 (D3) offenbart ein System zur Detektion eines Kurzschlusses.

Die Druckschrift US 2008/0043383 A1 (D4) offenbart eine Schutzschaltung für einen Dauermagnetgenerator zum Schutz vor Kurzschlüssen.

Es ist die der Erfindung zugrundeliegende Aufgabe, ein Kurzschlusssensor anzugeben, der eine verbesserte Unterscheidung zwischen einem normalen Überstrom und einem Kurzschlussstrom erlaubt.

Diese Aufgabe wird durch den Gegenstand mit den Merkmalen nach den unabhängigen Ansprüchen gelöst. Vorteilhafte Ausführungsformen der Erfindung sind Gegenstand der Figuren, der Beschreibung und der abhängigen Ansprüche.

Gemäß einem ersten Aspekt der Erfindung wird die Aufgabe durch einen Kurzschlusssensor zur Detektion eines Kurzschlussstromes in einer elektrischen Leitung gelöst, mit einem Integrator; und einer Kopplungseinrichtung, welche ausgebildet ist, den Integrator an die elektrische Leitung induktiv zu koppeln, und dem Integrator ein induziertes Signal zuzuführen; wobei der Integrator ausgebildet ist, das induzierte Signal zu integrieren, um ein integriertes Signal zu erhalten; und einer Detektionseinrichtung, welche ausgebildet ist, einen Amplitudenwert des integrierten Signals mit einem vorgegeben Schwellwert zu vergleichen, und den Kurzschlussstrom zu detektieren, falls der Amplitudenwert des integrierten Signals den vorgegeben Schwellwert überschreitet. Dadurch wird beispielsweise der technische Vorteil erreicht, dass eine schnelle Erfassung eines Kurzschlusses erfolgt und in kurzer Zeit eine Abschaltung eingeleitet werden kann. Durch die induktive Kopplung werden niedrige Frequenzen gedämpft und eine kürzere Reaktionszeit bis zur Abschaltung ermöglicht. Der Kurzschlusssensor ist beispielsweise ein Leiterplatten-Stromsensor für Drehstromanwendungen.

Durch die Erfindung wird der technische Vorteil erreicht, dass mit dem Kurzschlusssensor eine starke Dämpfung von Frequenzen unterhalb der Grenzfrequenz erreicht wird. Signale mit einer Frequenz von 50Hz, die in Motorsteuerungen vorkommen und Motorstarts in diesem Frequenzbereich werden beispielsweise nicht erfasst und fehlinterpretiert.

In einer weiteren vorteilhaften Ausführungsform des Kurzschlusssensors ist die Grenzfrequenz derart gewählt, dass die integrierende Wirkung für das Nutzsignal minimal ist. Dadurch wird beispielsweise der technische Vorteil erreicht, dass das Nutzsignal durch die Filtercharakteristik nicht beeinträchtigt wird. Der Kurzschlusssensor weist eine Grenzfrequenz auf, ab der der Funktionsbereich des Kurzschlusssensors beginnt.

In einer weiteren vorteilhaften Ausführungsform des Kurzschlusssensors umfasst der Integrator einen Kondensator und einen Widerstand, wobei der Kondensator und der Widerstand ein RC-Glied bilden, oder wobei der Integrator mittels eines Prozessors implementiert ist, wobei der Prozessor ausgebildet ist, das induzierte Signal digital zu integrieren, oder wobei der Integrator mittels einer Operationsverstärkerschaltung umfassend ein RC-Glied gebildet ist. Dadurch wird beispielsweise der technische Vorteil erreicht, dass der Kondensator als analoger Speicher dient, in dem die Spannung über die Zeit aufaddiert wird. Zudem wird beispielsweise der technische Vorteil erreicht, dass der Kurzschlusssensor die ursprüngliche Form einer Spannung erhält.

In einer weiteren vorteilhaften Ausführungsform des Kurzschlusssensors umfasst die Kopplungseinrichtung eine erste Induktivität zum induktiven Koppeln der Kopplungseinrichtung an die elektrische Leitung. Die erste Spule ist beispielsweise eine Planarspule, eine Luftspule, eine Spiral-Flachspule, eine Zylinderspule oder eine Ringspule. Dadurch wird beispielsweise der technische Vorteil erreicht, dass eine effiziente induktive Kopplung erreicht wird.

In einer weiteren vorteilhaften Ausführungsform des Kurzschlusssensors ist der Integrator der ersten Induktivität nachgeschaltet. Dadurch wird beispielsweise der technische Vorteil erreicht, dass ein induziertes Signal auf einfache Weise zugeführt werden kann.

In einer weiteren vorteilhaften Ausführungsform des Kurzschlusssensors umfasst die Kopplungseinrichtung eine zweite Induktivität, welche mit der ersten Induktivität induktiv gekoppelt ist. Dadurch wird beispielsweise der technische Vorteil erreicht, dass der Kurzschlusssensor seriell in die Stromleitung eingesetzt werden kann. Die Stromleitung weist eine Induktivität durch das eigene Magnetfeld auf, die zur induktiven Kopplung mit der zweiten Induktivität verwendet wird.

In einer weiteren vorteilhaften Ausführungsform des Kurzschlusssensors umfasst der Kurzschlusssensor Anschlüsse zum Anschließen der elektrischen Leitung an die Kopplungseinrichtung. Dadurch wird beispielsweise der technische Vorteil erreicht, dass der Kurzschlusssensor auf einfache Weise in die Stromleitung integriert werden kann.

In einer weiteren vorteilhaften Ausführungsform des Kurzschlusssensors umfasst der Kurzschlusssensor eine Abschalteinrichtung zum Unterbrechen der elektrischen Leitung. Dadurch wird beispielsweise der technische Vorteil erreicht, dass eine schnelle Erfassung eines Kurzschlusses erfolgt und in kurzer Zeit eine Abschaltung eingeleitet werden kann.

In einer weiteren vorteilhaften Ausführungsform des Kurzschlusssensors ist die Detektionseinrichtung ausgebildet, die Abschalteinrichtung im Falle eines detektierten Stromkurzschlusses zum Unterbrechen der elektrischen Leitung anzusteuern. Dadurch wird beispielsweise ebenfalls der technische Vorteil erreicht, dass in kurzer Zeit eine Abschaltung eingeleitet wird und eine Beschädigung einer Elektronik durch den Kurzschluss verhindert wird.

In einer weiteren vorteilhaften Ausführungsform des Kurzschlusssensors ist die eine Detektionseinrichtung ausgebildet, eine Mehrzahl von Amplitudenwerten des integrierten Signals mit dem vorgegeben Schwellwert zu vergleichen, und den Kurzschlussstrom zu detektieren, falls einer der Amplitudenwerte des integrierten Signals den vorgegeben Schwellwert überschreitet. Dadurch wird beispielsweise ebenfalls der technische Vorteil erreicht, dass der Kurzschlussstrom zuverlässig erkannt werden kann.

In einer weiteren vorteilhaften Ausführungsform des Kurzschlusssensors ist die Detektionseinrichtung dem Integrator nachgeschaltet und umfasst einen Prozessor, wobei der Prozessor einen Komparator implementiert, welcher ausgebildet ist, den Amplitudenwert des integrierten Signals mit dem vorgegeben Schwellwert zu vergleichen. Dadurch wird beispielsweise ebenfalls der technische Vorteil erreicht, dass eine flexibel konfigurierbare Kurzschlusserfassung realisiert wird.

In einer weiteren vorteilhaften Ausführungsform des Kurzschlusssensors ist der Prozessor ausgebildet ist, ein Abschaltsignal zum Unterbrechen der elektrischen Leitung im Falle eines detektierten Stromkurzschlusses auszugeben. Dadurch wird beispielsweise ebenfalls der technische Vorteil erreicht, dass eine Abschalteinrichtung angesteuert werden kann.

In einer weiteren vorteilhaften Ausführungsform des Kurzschlusssensors umfasst der Kurzschlusssensor ferner einen Analog-Digitalwandler, um das induzierte Signal oder um das integrierte Signal zu digitalisieren. Dadurch wird beispielsweise ebenfalls der technische Vorteil erreicht, dass eine digitale Verarbeitung des Signals durchgeführt werden kann.

Gemäß einem zweiten Aspekt der Erfindung wird die Aufgabe durch ein Verfahren zum Detektieren eines Kurzschlussstromes in einer elektrischen Leitung mittels eines Kurzschlusssensors gelöst, wobei der Kurzschlusssensor einen Integrator und eine Kopplungseinrichtung zum induktiven Koppeln des Integrators an die elektrische Leitung umfasst, um dem Integrator ein induziertes Signal zuzuführen, wobei das Verfahren die Schritte eines Integrierens des induzierten Signals durch den Integrator (105), um ein integriertes Signal zu erhalten; und Vergleichens eines Amplitudenwerts des integrierten Signals mit einem vorgegeben Schwellwert umfasst, um den Kurzschlussstrom zu detektieren, falls der Amplitudenwert des integrierten Signals den vorgegeben Schwellwert überschreitet. Dadurch werden die gleichen technischen Vorteile wie durch den Kurzschlussstromsensor nach dem ersten Aspekt erreicht.

In einer vorteilhaften Ausführungsform des Verfahrens umfasst das Verfahren den Schritt eines Unterbrechens der elektrischen Leitung bei detektiertem Kurzschlussstrom. Dadurch wird beispielsweise der technische Vorteil erreicht, dass eine Beschädigung einer Elektronik durch den Kurzschluss verhindert wird.

Ausführungsbeispiele der Erfindung sind in den Zeichnungen dargestellt und werden im Folgenden näher beschrieben.

Es zeigen:
- Fig. 1: ein Diagramm eines Anlaufstromes in einem Motor;
- Fig. 2: ein Diagramm eines Stromes bei einem Kurzschluss;
- Fig. 3: ein Diagramm einer induzierten Spannung in Abhängigkeit der Frequenz und einen Frequenzgang eines Tiefpassfilters;
- Fig. 4: eine schematische Ansicht eines Kurzschlusssensors; und
- Fig. 5: ein Diagramm eines zeitlichen Verlaufs eines Kurzschlusses und einer Abschaltung

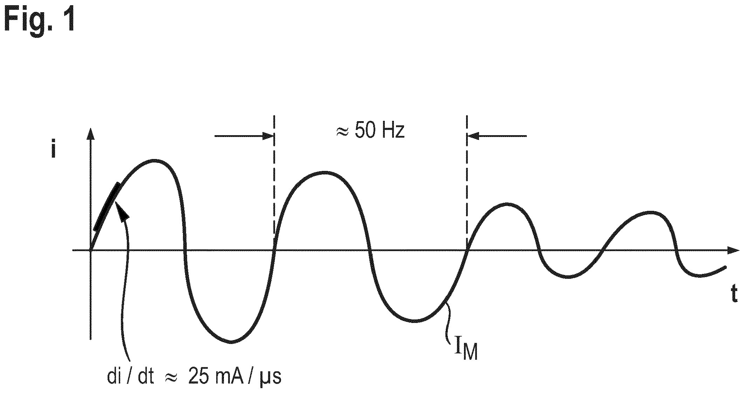

Fig. 1 zeigt ein Diagramm eines Anlaufstromes i in einem Elektromotor in Abhängigkeit der Zeit t. Der Elektromotor wird mit einem oszillierenden Strom I_{M} betrieben, der eine Frequenz von 50 Hz aufweist. Typische Stromanstiegsgeschwindigkeiten bei einem Motorstart betragen ca. 25mA/µs. Bei einem normalen Motorstart werden Amplituden von 6 bis 10 x I_{Nenn} im Einschaltmoment des Motors erreicht.

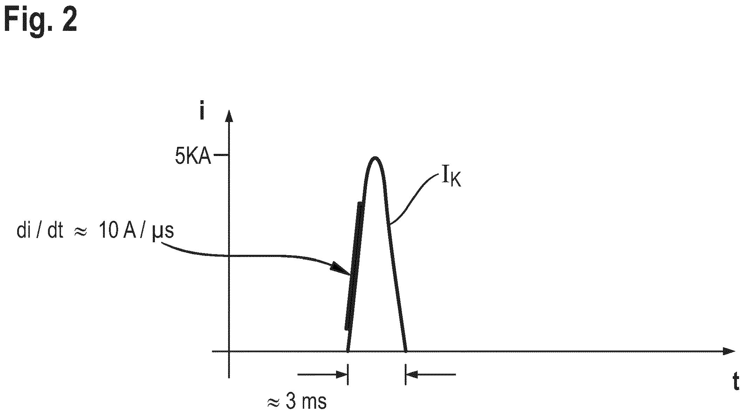

Fig. 2 zeigt ein Diagramm eines Stromes i bei einem Kurzschluss in Abhängigkeit der Zeit t. Ein Kurzschlussstrom weist einen sehr viel schnelleren Anstieg als ein Strom bei einem Motorstart auf. Ein Kurzschlussstrom weist beispielsweise eine Stromanstiegsgeschwindigkeit von 10A/µs auf.

Bei einer Verwendung von Stromwandlern zur Erfassung von Kurzschlussströmen liegen die Schwellen zum Auslösen sehr niedrig, so dass diese bereits durch einen Motorstart erreicht werden können. In diesem Fall finden eine fehlerhafte Detektion eines vermeintlichen Kurzschlussstromes und die Einleitung einer Abschaltung statt.

Zur Lösung dieses Problems findet durch einen Kurzschlusssensor mit einem Mikroprozessor kontinuierlich eine Bewertung der Anstiegszeit di/dt statt. Im Allgemeinen können jedoch andere Berechnungseinrichtungen als ein Mikroprozessor verwendet werden. Durch den Mikroprozessor wird ständig die Stromanstiegsgeschwindigkeit di/dt berechnet und mit einem Referenzwert verglichen. Vor dem Prozessor kann ein A/D-Wandler angeordnet sein oder Prozessor wandelt analoge in digitale Signale um.

Sobald die Stromanstiegsgeschwindigkeit di/dt über einem bestimmten Referenzwert liegt, wird das Vorliegen eines Kurzschlusses erfasst. Diese Berechnung ist jedoch nicht zwingend erforderlich. Es kann auch direkt die Sensorausgangsspannung mit dem Referenzwert verglichen und dieses als Maß verwendet werden. Die niedrigen Frequenzen beispielsweise eines Motoranlaufstroms werden systembedingt gedämpft und führen somit nicht zur Auslösung des Schwellwertes.

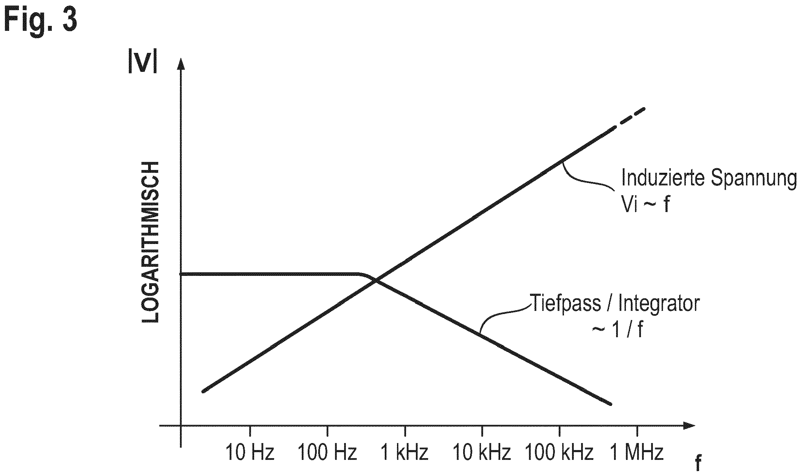

Fig. 3 zeigt ein doppelt logarithmisches Diagramm einer induzierten Spannung U_{ind} und eines Frequenzganges eines Tiefpassfilters oder Integrators in Abhängigkeit der Frequenz f. Durch eine induktive Kopplung des Kurzschlusssensors mit der Stromleitung werden überwiegend hochfrequente Signale übertragen. Dies liegt nach dem Induktionsgesetz darin begründet, dass die induzierte Spannung in dem Kurzschlusssensor proportional zu dem Stromanstieg U_{ind} ∼ di/dt in einer Stromleitung ist. Im Frequenzbereich gilt U_{ind} ∼ jωl. Das induzierte Signal kann daher bereits eine Ableitung nach der Zeit di/dt sein. Daher nimmt die induzierte oder messbare Spannung in dem Kurzschlusssensor mit zunehmender Frequenz f zu.

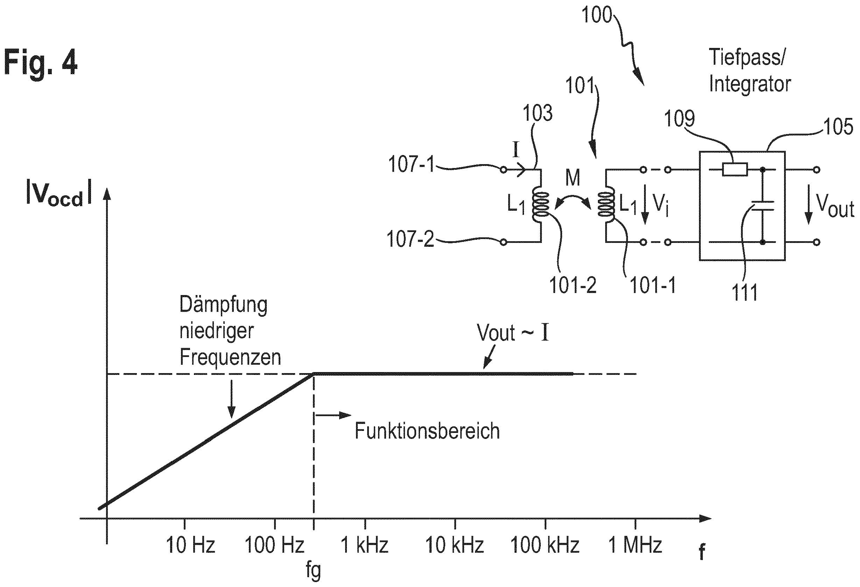

Um ein zum Messstrom proportionales Ausgangssignal zu erhalten, wird das Messsignal integriert oder mit einer 1/f-Charakteristik tiefpassgefiltert. Wird der Tiefpass oder Integrator mit einer unteren Grenzfrequenz f_{g} bereitgestellt, wird das in Fig. 4 dargestellte Ausgangsignal Vₒᵤₜ erhalten. Die Charakteristik des Ausgangssignals ergibt sich aus der Multiplikation der beiden Frequenzverläufe aus Fig. 3. Ab der Grenzfrequenz f_{g} des Tiefpasses wird ein Ausgangssignal erhalten, das proportional zum Messstrom verläuft. Bei sehr hohen Frequenzen kann sich das Verhalten aufgrund parasitärer Effekte ändern (nicht dargestellt). Somit ergibt sich ein Funktionsbereich des Kurzschlusssensors ab der einstellbaren Grenzfrequenz f_{g} bis zu einer oberen natürlichen Grenzfrequenz. Dieser Funktionsbereich wird erfindungsgemäß so gewählt, dass Spektren von typischen Kurzschlussstromverläufen gut mit dem Funktionsbereich übereinstimmen und somit gut erfasst werden können. Niedrige Frequenzen des Nutzsignals werden durch die induktive Kopplung nur schwach übertragen und durch die untere Grenzfrequenz des Integrators bzw. Tiefpassfilters nicht oder nur wenig verstärkt, so dass sich effektiv eine nur sehr schwache Übertragung einstellt, was erfindungsgemäß erwünscht ist. Somit kann durch den Kurzschlusssensor eine gute Trennung zwischen Nutzsignal und zu detektierenden Kurzschlusssignalen erreicht werden.

Fig. 4 zeigt eine schematische Ansicht eines Kurzschlusssensors 100. Der Kurzschlusssensor 100 wird über die Anschlüsse 107-1 und 107-2 an eine Stromleitung 103 angeschlossen, an der der Kurzschluss detektiert werden soll. Der Kurzschlusssensor 100 umfasst eine Kopplungseinrichtung 101 zum induktiven Koppeln des Kurzschlusssensors 100 an die Stromleitung 103, um eine induzierte Spannung zu erfassen. Die Kopplungseinrichtung 101 umfasst eine erste Induktivität 101-1 zum induktiven Koppeln des Kurzschlusssensors 100 an die Stromleitung 103 und eine zweite Induktivität 101-2 zum Anschließen des Kurzschlusssensors 100 an die Stromleitung 103. Die zweite Induktivität 101-2 kann durch den induktiven Anteil der elektrischen Stromleitung 103 gebildet sein.

Somit ist es in einer Abwandlung von Fig. 4 auch möglich, eine ursprüngliche Stromleitung in die räumliche Nähe des Kurzschlusssensors zu bringen und Kurzschlussströme ohne Unterbrechung der Stromleitung zu detektieren, was beispielsweise eine nachträgliche Montage des Kurzschlusssensors an bestehende Anlagen ermöglicht, ohne die Stromleitungen unterbrechen zu müssen. In diesem Fall werden die Anschlüsse 107.-1 und 107-2 nicht benötigt.

Der Kurzschlusssensor 100 umfasst weiter einen Integrator 105 zum Integrieren der induzierten Spannung mit einer unteren Grenzfrequenz oder ein Tiefpassfilter 105 zum Tiefpassfiltern der induzierten Spannung. Das Tiefpassfilter 105 ist ein Filter, das Signalanteile mit Frequenzen unterhalb einer Grenzfrequenz f_{g} annähernd ungeschwächt passieren lässt, Anteile mit höheren Frequenzen dagegen abschwächt. Der Integrator 105 ist eine Schaltung mit einer frequenzabhängigen Gegenkopplung, beispielsweise in Form eines Kondensators 111. Der Kondensator 111 dient dabei als analoger Speicher, in dem eine Eingangsspannung über die Zeit aufaddiert wird.

Der Integrator 105 umfasst einen Widerstand 109 und einen Kondensator 111, die zusammen ein RC-Glied bilden. Für niedrige Frequenzen unterhalb der Grenzfrequenz f_{g} tritt eine systembedingte Dämpfung durch die induktive Kopplung auf, die dazu genutzt wird, niederfrequente Ströme in der Stromleitung 103 nicht oder stark gedämpft zu messen. Wird die Grenzfrequenz oberhalb einer Frequenz von 50 Hz gewählt, kann eine starke Dämpfung von 50 Hz-Signalen erreicht werden. Motorstarts oder andere Stromereignisse, die in diesem Frequenzbereich liegen, werden nicht erfasst, so dass diese nicht fehlinterpretiert werden können.

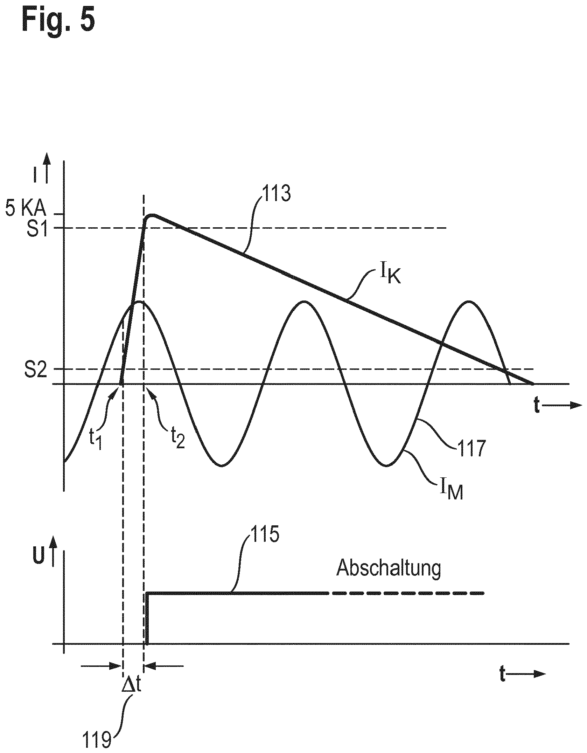

Fig. 5 zeigt ein Diagramm eines zeitlichen Verlaufs eines Kurzschlusses 113 und einer Abschaltung 115. Durch den Kurzschlusssensor 100 kann eine Schwelle zur Erfassung eines Kurzschlusses 113 von dem Referenzwert S1 auf S2 abgesenkt werden. In diesem Fall kann die Schwelle S2 unterhalb der Amplitude I_{M} 117 liegen.

Die Reaktionszeit des Kurzschlusssensors 100 verkürzt sich um ein Zeitintervall Δt 119. Durch diese Maßnahme wird eine Belastung in einem Motorschalter oder einer anderen empfindlichen Elektronik verringert und gleichzeitig die Wahrscheinlichkeit auf eine sichere Funktionsfähigkeit nach dem Kurzschluss erhöht. Der Kurzschlusssensor 100 kann eine Kombination aus dem Tiefpassfilter und einem Prozessor zum kontinuierlichen Berechnen eines Stromänderungswertes verwenden, um eine präzise Erfassung eines Kurzschlussstromes zu gewährleisten. Nach der Erfassung eines Kurzschlusses durch den Kurzschlusssensor 100 kann eine Abschaltung 115 oder ein Strombypass geschaltet werden, um Elektronikbaugruppen und Halbleiter zu schützen.

Das Bezugszeichen 113 bezeichnet einen Stromverlauf eines typischen Kurzschlussstroms. Das Bezugszeichen 117 bezeichnet einen Nennstrom oder Motoranlaufstrom. Die Anstiegszeit des Kurzschlussstroms ist wesentlich steiler oder schneller als die des Nennstroms. Würde der Kurzschlusssensor 100 frequenzunabhängig reagieren und somit nur auf die Amplitude des Stromsignals reagieren können, müsste eine Detektionsschwelle S1 gewählt werden, die zum Zeitpunkt t2 erreicht wird. Ab diesem Zeitpunkt könnte eine Hilfsabschaltung initiiert werden. Der Strom und die Energie können an diesem Zeitpunkt schon sehr hoch sein.

Durch die frequenzabhängige Auslegung des Kurzschlusssensors 100 kann die Detektionsschwelle von S1 auf S2 reduziert werden. Durch die Dämpfung niedriger Frequenzen kann ein Nennstromsignal 117 trotz Erreichen der Schwelle S2 den Kurzschlusssensor 100 nicht auslösen, da der Kurzschlusssensor 100 insgesamt eine Hochpasscharakteristik mit einer Grenzfrequenz größer die Nennstromfrequenz aufweist und somit das Signal des Nennstroms trotz Erreichen der Schwelle S2 nicht detektiert.

Sobald ein Kurzschlussstrom mit einer schnellen Anstiegsgeschwindigkeit, d.h. hohen Frequenz, die Schwelle S2 erreicht, wird der Kurzschluss detektiert und die Schutzeinrichtung (z.B. Hilfskurzschluss) kann initiiert werden. Durch die Reduzierung der Schwelle von S1 auf S2 kann die Reaktionszeit des Sensors um Δt (t2-t1) verbessert werden und eine Abschaltung früher erreicht werden. Hierdurch können sich verschiedene Vorteile ergeben.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Kurzschlusssensor
- 101: Kopplungseinrichtung
- 101-1: erste Induktivität
- 101-2: zweite Induktivität
- 103: Stromleitung
- 105: Integrator/Tiefpassfilter
- 107-1: Anschluss
- 107-2: Anschluss
- 109: Widerstand
- 111: Kondensator
- 113: Kurzschluss
- 115: Abschaltung
- 117: Amplitude
- 119: Zeitintervall

## Patentansprüche

1. Kurzschlusssensor (100) zur Detektion eines Kurzschlussstromes in einer elektrischen Leitung (103), mit:
einem Integrator (105), wobei der Integrator (105) eine Filtercharakteristik mit einer unteren Grenzfrequenz aufweist, welche oberhalb einer Netzfrequenz liegt; und
einer Kopplungseinrichtung (101), welche ausgebildet ist, den Integrator (105) an die elektrische Leitung (103) induktiv zu koppeln, und dem Integrator (105) ein induziertes Signal zuzuführen;
wobei der Integrator (105) ausgebildet ist, das induzierte Signal zu integrieren, um ein integriertes Signal zu erhalten; und
einer Detektionseinrichtung (107), welche ausgebildet ist, einen Amplitudenwert des integrierten Signals mit einem vorgegeben Schwellwert zu vergleichen, und den Kurzschlussstrom zu detektieren, falls der Amplitudenwert des integrierten Signals den vorgegeben Schwellwert überschreitet.

2. Kurzschlusssensor (100) nach einem der vorangehenden Ansprüche, wobei der Integrator (105) einen Kondensator (111) und einen Widerstand (109) umfasst, wobei der Kondensator (111) und der Widerstand (109) ein RC-Glied bilden, oder wobei der Integrator (105) mittels eines Prozessors implementiert ist, wobei der Prozessor ausgebildet ist, das induzierte Signal digital zu integrieren, oder wobei der Integrator (105) mittels einer Operationsverstärkerschaltung umfassend ein RC-Glied gebildet ist.

3. Kurzschlusssensor (100) nach einem der vorangehenden Ansprüche, wobei die Kopplungseinrichtung (101) eine erste Induktivität (101-1) zum induktiven Koppeln der Kopplungseinrichtung (101) an die elektrische Leitung (103) umfasst.

4. Kurzschlusssensor (100) nach Anspruch 3, wobei der Integrator (105) der ersten Induktivität (101-1) nachgeschaltet ist.

5. Kurzschlusssensor (100) nach Anspruch 3 oder 4, wobei die Kopplungseinrichtung (101) eine zweite Induktivität (101-2) umfasst, welche mit der ersten Induktivität (101-1) induktiv gekoppelt ist.

6. Kurzschlusssensor (100) nach Anspruch 5, wobei der Kurzschlusssensor (100) Anschlüsse (107-1, 107-2) zum Anschließen der elektrischen Leitung (103) an die Kopplungseinrichtung (101) umfasst.

7. Kurzschlusssensor (100) nach einem der vorangehenden Ansprüche, wobei der Kurzschlusssensor (100) eine Abschalteinrichtung zum Unterbrechen der elektrischen Leitung (103) umfasst.

8. Kurzschlusssensor (100) nach Anspruch 7, wobei die Detektionseinrichtung (107) ausgebildet ist, die Abschalteinrichtung im Falle eines detektierten Stromkurzschlusses zum Unterbrechen der elektrischen Leitung anzusteuern.

9. Kurzschlusssensor (100) nach einem der vorangehenden Ansprüche, wobei die eine Detektionseinrichtung (107) ausgebildet ist, eine Mehrzahl von Amplitudenwerten des integrierten Signals mit dem vorgegebenen Schwellwert zu vergleichen, und den Kurzschlussstrom zu detektieren, falls einer der Amplitudenwerte des integrierten Signals den vorgegeben Schwellwert überschreitet.

10. Kurzschlusssensor (100) nach einem der vorangehenden Ansprüche, wobei die Detektionseinrichtung (107) dem Integrator (105) nachgeschaltet ist und einen Prozessor umfasst, wobei der Prozessor einen Komparator implementiert, welcher ausgebildet ist, den Amplitudenwert des integrierten Signals mit dem vorgegeben Schwellwert zu vergleichen.

11. Kurzschlusssensor (100) nach Anspruch 10, wobei der Prozessor ausgebildet ist, ein Abschaltsignal zum Unterbrechen der elektrischen Leitung (103) im Falle eines detektierten Stromkurzschlusses auszugeben.

12. Kurzschlusssensor (100) nach einem der vorangehenden Ansprüche, die ferner einen Analog-Digitalwandler umfasst, um das induzierte Signal oder um das integrierte Signal zu digitalisieren.

13. Verfahren zum Detektieren eines Kurzschlussstromes in einer elektrischen Leitung (103) mittels eines Kurzschlusssensors (100), wobei der Kurzschlusssensor (100) einen Integrator (105), wobei der Integrator (105) eine Filtercharakteristik mit einer unteren Grenzfrequenz aufweist, welche oberhalb einer Netzfrequenz liegt, und eine Kopplungseinrichtung (101) zum induktiven Koppeln des Integrators (105) an die elektrische Leitung (103) umfasst, um dem Integrator (105) ein induziertes Signal zuzuführen, wobei das Verfahren die folgenden Schritte umfasst:
Integrieren des induzierten Signals durch den Integrator (105), um ein integriertes Signal zu erhalten; und
Vergleichen eines Amplitudenwerts des integrierten Signals mit einem vorgegeben Schwellwert, und den Kurzschlussstrom zu detektieren, falls der Amplitudenwert des integrierten Signals den vorgegeben Schwellwert überschreitet.

14. Verfahren nach Anspruch 13, wobei das Verfahren den Schritt eines Unterbrechens der elektrischen Leitung (103) bei detektiertem Kurzschlussstrom umfasst.

## Claims

1. Short-circuit sensor (100) for detecting a short-circuit current in an electrical line (103), comprising:
an integrator (105), wherein the integrator (105) has a filter characteristic with a lower cut-off frequency which is above a mains frequency; and
a coupling device (101) which is configured to inductively couple the integrator (105) to the electrical line (103) and to feed an induced signal to the integrator (105);
wherein the integrator (105) is configured to integrate the induced signal in order to obtain an integrated signal; and
a detection device (107) which is configured to compare an amplitude value of the integrated signal with a predefined threshold value, and to detect the short-circuit current if the amplitude value of the integrated signal exceeds the predefined threshold value.

2. Short-circuit sensor (100) according to one of the preceding claims, wherein the integrator (105) comprises a capacitor (111) and a resistor (109), wherein the capacitor (111) and the resistor (109) form an RC element, or wherein the integrator (105) is implemented by means of a processor, wherein the processor is configured to integrate the induced signal digitally, or wherein the integrator (105) is formed by means of an operational amplifier circuit comprising an RC element.

3. Short-circuit sensor (100) according to one of the preceding claims, wherein the coupling device (101) comprises a first inductance (101-1) for inductively coupling the coupling device (101) to the electrical line (103).

4. Short-circuit sensor (100) according to claim 3, wherein the integrator (105) is arranged downstream of the first inductance (101-1).

5. Short-circuit sensor (100) according to claim 3 or 4, wherein the coupling device (101) comprises a second inductance (101-2), which is inductively coupled to the first inductance (101-1).

6. Short-circuit sensor (100) according to claim 5, wherein the short-circuit sensor (100) comprises terminals (107-1, 107-2) for connecting the electrical line (103) to the coupling device (101).

7. Short-circuit sensor (100) according to one of the preceding claims, wherein the short-circuit sensor (100) comprises a switch-off device for interrupting the electrical line (103).

8. Short-circuit sensor (100) according to claim 7, wherein the detection device (107) is configured to actuate the switch-off device to interrupt the electrical line in the event of a short-circuit being detected.

9. Short-circuit sensor (100) according to one of the preceding claims, wherein the detection device (107) is configured to compare a plurality of amplitude values of the integrated signal with the predefined threshold value, and to detect the short-circuit current if one of the amplitude values of the integrated signal exceeds the predefined threshold value.

10. Short-circuit sensor (100) according to one of the preceding claims, wherein the detection device (107) is arranged downstream of the integrator (105) and comprises a processor, wherein the processor implements a comparator which is configured to compare the amplitude value of the integrated signal with the predefined threshold value.

11. Short-circuit sensor (100) according to claim 10, wherein the processor is configured to output a switch-off signal to interrupt the electrical line (103) in the event of a short-circuit being detected.

12. Short-circuit sensor (100) according to one of the preceding claims, which further comprises an analogue-to-digital converter for digitizing the induced signal or for digitizing the integrated signal.

13. Method for detecting a short-circuit current in an electrical line (103) by means of a short-circuit sensor (100), wherein the short-circuit sensor (100) comprises an integrator (105), wherein the integrator (105) has a filter characteristic with a lower cut-off frequency which is above a mains frequency, and a coupling device (101) for inductively coupling the integrator (105) to the electrical line (103) in order to feed an induced signal to the integrator (105), wherein the method comprises the following steps:
integrating the induced signal, by means of the integrator (105), in order to obtain an integrated signal; and
comparing an amplitude value of the integrated signal with a predefined threshold value, and detecting the short-circuit current if the amplitude value of the integrated signal exceeds the predefined threshold value.

14. Method according to claim 13, wherein the method comprises the step of interrupting the electrical line (103) in the event of a short-circuit current being detected.

## Revendications

1. Détecteur de court-circuit (100) destiné à détecter un courant de court-circuit sur une ligne électrique (103), comprenant :
un intégrateur (105), ledit intégrateur (105) présentant une caractéristique de filtre avec une fréquence limite inférieure située au-dessus d'une fréquence de réseau ; et
un dispositif de couplage (101), prévu pour coupler inductivement l'intégrateur (105) à la ligne électrique (103), et pour appliquer un signal induit à l'intégrateur (105) ;
l'intégrateur (105) étant prévu pour intégrer le signal induit, afin d'obtenir un signal intégré ; et
un dispositif de détection (107), prévu pour comparer une valeur d'amplitude du signal intégré à une valeur seuil prédéfinie, et détecter le courant de court-circuit si la valeur d'amplitude du signal intégré dépasse la valeur seuil prédéfinie.

2. Détecteur de court-circuit (100) selon la revendication 1, où l'intégrateur (105) comprend un condensateur (111) et une résistance (109), le condensateur (111) et la résistance (109) formant un élément RC, ou bien où l'intégrateur (105) est implémenté au moyen d'une processeur, ledit processeur étant prévu pour intégrer le signal numérique induit, ou bien où l'intégrateur (105) est formé au moyen d'un circuit amplificateur opérationnel comprenant un élément RC.

3. Détecteur de court-circuit (100) selon l'une des revendications précédentes, où le dispositif de couplage (101) comprend une première inductance (101-1) pour le couplage inductif du dispositif de couplage (101) à la ligne électrique (103).

4. Détecteur de court-circuit (100) selon la revendication 3, où l'intégrateur (105) est monté en aval de la première inductance (101-1).

5. Détecteur de court-circuit (100) selon la revendication 3 ou la revendication 4, où le dispositif de couplage (101) comprend une deuxième inductance (101-2), laquelle est couplée inductivement à la première inductance (101-1).

6. Détecteur de court-circuit (100) selon la revendication 5, où le détecteur de court-circuit (100) comprend des connexions (107-1, 107-2) pour le raccordement de la ligne électrique (103) au dispositif de couplage (101).

7. Détecteur de court-circuit (100) selon l'une des revendications précédentes, ledit détecteur de court-circuit (100) comprenant un dispositif de coupure pour la mise hors tension de la ligne électrique (103).

8. Détecteur de court-circuit (100) selon la revendication 7, où le dispositif de détection (107) est prévu pour commander la mise hors tension de la ligne électrique par le dispositif de coupure en cas de détection d'un court-circuit électrique.

9. Détecteur de court-circuit (100) selon l'une des revendications précédentes, où le premier dispositif de détection (107) est prévu pour comparer une pluralité de valeurs d'amplitude du signal intégré à la valeur seuil prédéfinie, et détecter le courant de court-circuit si une des valeurs d'amplitude du signal intégré dépasse la valeur seuil prédéfinie.

10. Détecteur de court-circuit (100) selon l'une des revendications précédentes, où le dispositif de détection (107) est monté en aval de l'intégrateur (105) et comprend un processeur, ledit processeur implémentant un comparateur prévu pour comparer la valeur d'amplitude du signal intégré à la valeur seuil prédéfinie.

11. Détecteur de court-circuit (100) selon la revendication 10, où le processeur est prévu pour émettre un signal de coupure pour la mise hors tension de la ligne électrique (103) en cas de détection d'un court-circuit électrique.

12. Détecteur de court-circuit (100) selon l'une des revendications précédentes, comprenant en outre un convertisseur analogique-numérique pour numériser le signal induit ou le signal intégré.

13. Procédé de détection d'un courant de court-circuit sur une ligne électrique (103) au moyen d'un détecteur de court-circuit (100), ledit détecteur de court-circuit (100) comprenant un intégrateur (105), ledit intégrateur (105) présentant une caractéristique de filtre avec une fréquence limite inférieure située au-dessus d'une fréquence de réseau, et un dispositif de couplage (101) pour le couplage inductif de l'intégrateur (105) à la ligne électrique (103), afin d'appliquer un signal induit à l'intégrateur (105), ledit procédé comprenant les étapes suivantes :
intégration du signal induit par l'intégrateur (105) pour obtenir un signal intégré ; et
comparaison d'une valeur d'amplitude du signal intégré à une valeur seuil prédéfinie, et détection du courant de court-circuit si la valeur d'amplitude du signal intégré dépasse la valeur seuil prédéfinie.

14. Procédé selon la revendication 13, ledit procédé comprenant l'étape de mise hors tension de la ligne électrique (103) si un courant de court-circuit est détecté.
